# FASCICULE DE BREVET EUROPEEN

(11) **EP 3 932 152 B1**
(45) Date de publication et mention de la délivrance du brevet: **03.12.2025**
(21) Numéro de dépôt: 20713355.4
(22) Date de dépôt: 25.02.2020
(51) Int. Cl.: H05K 1/18, H05K 3/46, H05K 1/14, H05K 3/18

(54) **CARTE ÉLECTRONIQUE COMPRENANT DES COMPOSANTS DANS DES CAVITÉS ET DES PLAGES DE BRASAGE PARTAGÉES**
ELEKTRONIKKARTE MIT BESTANDTEILEN IN HÖHLEN UND GEMEINSAMEN LÖTUNGSBEREICHEN
ELECTRONIC BOARD COMPRISING COMPONENTS IN CAVITES AND SHARED BRASING PADS

(30) Priorité: 25.02.2019 FR 1901926
(43) Date de publication de la demande: 05.01.2022
(73) Titulaire: Safran Electronics & Defense, 75015 Paris (FR)
(72) Inventeur: CHOCTEAU, Philippe, 77550 MOISSY-CRAMAYEL (FR); LECORDIER, Denis, 77550 MOISSY-CRAMAYEL (FR)
(74) Mandataire: Regimbeau
(86) Numéro de dépôt international: PCT/FR2020/050363
(87) Numéro de publication internationale: WO 2020/174181

(56) Documents cités:
- JP-A- 2004 079 666
- US-A1- 2015 262 841
- US-A1- 2017 181 286
- US-A1- 2018 020 547

## Description

### DOMAINE DE L'INVENTION

L'invention concerne le domaine des cartes électroniques, en particulier lorsque ces cartes électroniques sont destinées à être intégrées dans un dispositif portable et embarqué, par exemple dans le domaine de l'aéronautique et spatial, et plus précisément la fixation de composants à des circuits imprimés.

### ARRIERE-PLAN TECHNOLOGIQUE

De manière connue en soi, une carte électronique peut comprendre des composants montés en surface (CMS), c'est-à-dire des composants électroniques brasés directement à la surface du circuit imprimé d'une carte électronique, des composants traversants, ou encore des circuits imprimés.

Habituellement, les CMS sont brasés en surface soit par refusion (« reflow soldering » en anglais), soit à la vague (« solder wave » en anglais).

Dans le cas du brasage par refusion, le circuit imprimé nu est tout d'abord sérigraphié en recouvrant les couches conductrices du circuit imprimés (généralement en cuivre) par une crème à braser à l'aide d'un écran de sérigraphie (ou pochoir) de sorte que seuls les emplacements destinés à recevoir les terminaisons des composants sont recouverts par la crème à braser. La crème à braser comprend, de manière connue en soi, un alliage métallique en suspension dans un flux de brasage. Puis les terminaisons des composants (CMS) sont posées sur la crème à braser avant de subir un traitement thermique de refusion, au cours duquel la chaleur fait refondre l'alliage et évaporer le flux de brasage de manière à former des joints de brasure à partir de l'alliage métallique présent dans la crème à braser.

Afin d'augmenter la densité d'implantation des composant d'un circuit imprimé comprenant des composants montés en surface, le document US 2014/158414 propose d'enterrer des composants dans le circuit imprimé. Plus précisément, une cavité est réalisée par découpe laser dans le circuit imprimé, après sa fabrication, de sorte à dévoiler des plages de brasage au fond de la cavité. Le composant est ensuite placé au fond de la cavité et brasé sur les plages de brasage, puis la carte électronique est sérigraphiée afin de noyer le composant une couche isolante. Cette solution permet ainsi de désencombrer la couche de peau de la carte électronique. Toutefois, la couche isolante dans laquelle est noyé le composant empêche le remplacement des composants en cas de défaillance de ceux-ci et complexifie la phase de développement de la carte électronique. De plus, l'enterrement de composants modifie la suppy chain et augmente le coût de fabrication du circuit imprimé, puisque les composants doivent être assemblés par le fournisseur de circuit imprimé.

Il a également été proposé dans le document FR 3 069 127 au nom de la Demanderesse un procédé de fabrication d'une carte électronique comprenant un circuit imprimé multicouche ayant au moins quatre couches conductrices séparées deux à deux par des couches isolantes, dont :
- une première et une deuxième couche conductrice de peau fixées sur une première et une deuxième couche isolante, respectivement, la première couche conductrice de peau étant sensiblement plane et définissant un plan normal à un axe Z,
- une première et une deuxième couche conductrice interne, s'étendant entre la première et la deuxième couche isolante, respectivement, et séparées par une troisième couche isolante, au moins la première couche conductrice interne étant traitée de manière à former au moins une plage de brasage.

Une première cavité est formée dans la première couche conductrice de peau et dans la première couche isolante, en face de la plage de brasage de la première couche conductrice interne, de sorte qu'au moins une partie de la plage de brasage soit dévoilée. Cette cavité est ensuite remplie avec un alliage métallique accompagné d'un flux de brasage, par exemple de la crème à braser, puis un composant électronique est placé en face de la première cavité. Enfin, un traitement thermique type refusion est appliqué au circuit imprimé sur lequel est placé le composant afin de transformer l'alliage métallique accompagné du flux de brasage en joint de brasure de manière à fixer le premier composant au circuit imprimé.

Ce procédé permet ainsi d'augmenter efficacement la densité d'implantation et la mixité des composants montés en surface en créant des cavités permettant de réduire l'encombrement de la carte électronique, tout en permettant le remplacement des CMS défectueux.

Ces procédés ont donc déjà permis d'augmenter la densité d'implantation de composants dans une carte électronique. Toutefois, l'industrie de l'aéronautique et du spatial reste en perpétuelle recherche d'amélioration des cartes électroniques. C'est en particulier le cas dans le domaine des filtres différentiels pour lesquels plusieurs composants électroniques discrets doivent être connectés ensemble. En effet, le filtre différentiel est d'autant plus efficace que les composants électroniques sont proches. Toutefois, les tolérances de fabrication, à l'inverse, nécessitent d'éloigner suffisamment les composants électroniques pour éviter qu'ils ne se collent lors de l'étape de brasage, car un tel collage a pour effet de déformer les joints de brasure et donc de réduire drastiquement leur durée de vie.

Le document US 2015/262841 décrit une carte électronique comprenant un circuit imprimé comprenant une couche isolante dans laquelle est formée une cavité et une plage de brasage en surface fixée sur la couche isolante. Un composant électronique est placé dans la cavité, tandis qu'un ou plusieurs composants électroniques sont brasés en surface par-dessus cette cavité. La cavité est en outre remplie avec une résine de protection et le ou les composants placés sur la cavité sont empilés en utilisant des couches d'adhésif. Cette configuration permet d'augmenter la densité d'implantation. Toutefois, une telle carte électronique est difficile à réparer, les composants étant moins accessibles que lorsqu'ils tous sont placés sur une même surface, car peu accessibles.

Les documents US 2018/020547 et US 2017/0181286 décrivent une carte électronique comprenant un circuit imprimé comprenant une couche isolante dans laquelle est formée une cavité et une plage de brasage en surface fixée sur la couche isolante. Un composant électronique est placé dans la cavité, tandis qu'un composant électronique est brasé par-dessus cette cavité, en surface. Toutefois, comme dans le document US 2015/262841, ces cartes électroniques ne sont pas optimales en termes de réparabilité / remplacement des composants.

### RESUME DE L'INVENTION

Un objectif de l'invention est donc de proposer un nouveau procédé permettant d'augmenter encore la densité d'implantation et la mixité de composants électroniques sur un circuit imprimé, sans réduire leur durée de vie, en rendant possible l'assemblage sans contrainte de composants variés, qu'il s'agisse de composants à pas fin, de grande taille, quelle que soit la forme de leurs terminaisons, ce nouveau procédé étant en outre simple à réaliser et de coût modéré sans pour autant impacter le rendement d'assemblage de la carte électronique.

Pour cela, l'invention propose une carte électronique et un procédé de fabrication associé conformes aux revendications annexées. Des modes de réalisation sont définis dans les revendications dépendantes.

### BREVE DESCRIPTION DES DESSINS

D'autres caractéristiques, buts et avantages de la présente invention apparaîtront mieux à la lecture de la description détaillée qui va suivre, et au regard des dessins annexés donnés à titre d'exemples non limitatifs et sur lesquels :
Les figures 1 à 4 des vues de côté de plusieurs variantes d'un exemple de réalisation d'une carte électronique conforme à l'invention.

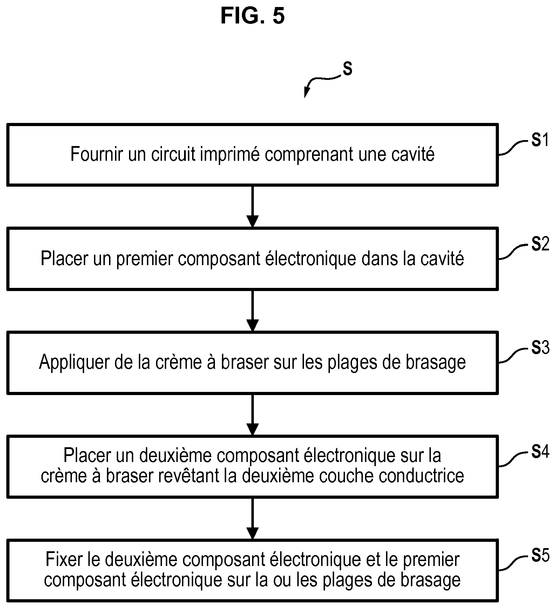

La figure 5 est un organigramme représentant différentes étapes d'un procédé de fabrication d'une carte électronique conforme à une première forme de réalisation de l'invention.

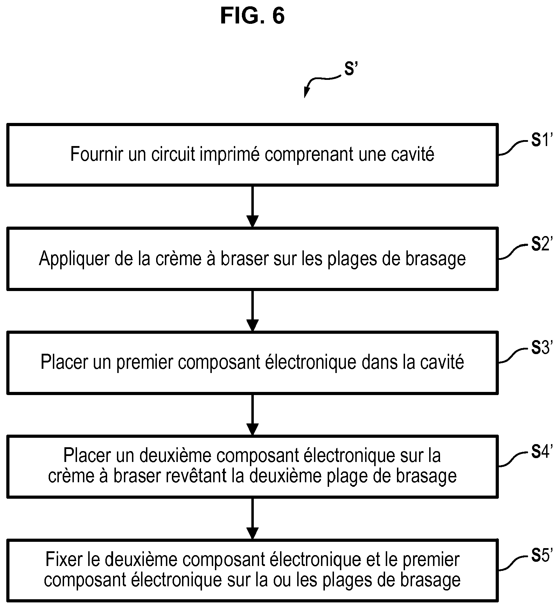

La figure 6 est un organigramme représentant différentes étapes d'un procédé de fabrication d'une carte électronique conforme à une deuxième forme de réalisation de l'invention.
La figure 7 est un exemple de réalisation d'une cavité formant une mire pouvant être utilisée dans un procédé de fabrication conforme à l'invention.

### DESCRIPTION DETAILLEE D'UN MODE DE REALISATION

Une carte électronique 1 comprend un circuit imprimé 10 comportant des couches conductrices séparées par des couches isolantes sur lequel sont fixés des composants électroniques.

De manière générale, un circuit imprimé 10 peut être du type monocouche (également appelé simple couche) et ne comprendre qu'une seule couche conductrice, double couche (également appelé double face) et comprendre une couche conductrice de part et d'autre d'une couche isolante 11, 13 ou multicouche et comprendre au moins quatre couches conductrices.

Les couches isolantes 11, 13 peuvent comprendre, de manière connue en soi, une résine epoxy et des fibres de verre. Les couches conductrices quant à elles peuvent être en cuivre (ou dans un alliage à base de cuivre).

Par composant électronique, on comprendra dans ce qui suit tout élément destiné à être assemblé avec d'autres afin de réaliser une ou plusieurs fonctions électroniques. A titre d'exemple non limitatif, un composant électronique peut comprendre un composant électronique discret tel qu'un composant monté en surface (CMS) (typiquement une résistance, un condensateur, un BGA (acronyme anglais de Ball Grid Array pour matrice de billes), etc.) ou un composant traversant, ou encore un circuit imprimé sur lequel sont fixés un ou plusieurs composants électroniques discrets.

Une carte électronique 1 comprend un circuit imprimé 10, au moins un premier composant électronique 2 et un deuxième composant électronique 3. Le circuit imprimé 10 peut être monocouche, bicouche ou multicouche.

Le circuit imprimé 10 comprend une première couche isolante 11 et une deuxième couche isolante 13 fixée sur la première couche isolante 11. Comme nous le verrons par la suite, la première couche isolante 11 et la deuxième couche isolante 13 peuvent être formées intégralement et en une seule pièce ou en variante être séparées par une première couche conductrice traitée de sorte à former au moins une plage de brasage en fond de cavité 12.

Une deuxième couche conductrice est fixée sur la deuxième couche isolante 13 à l'opposé de la première couche isolante 11. La deuxième couche conductrice est traitée de sorte à former au moins une plage de brasage en surface 14. Une cavité 5 débouchante, qui loge le premier composant électronique 2, est formée dans la deuxième couche isolante 13. Par débouchante, on comprendra ici que la cavité n'est pas obturée et est ouverte au niveau de la surface de la deuxième couche isolante 13.

Afin d'augmenter la densité d'implantation des composants électroniques de la carte électronique 1 et de permettre le cas échéant leur mixité, le deuxième composant électronique 3 est placé sur la deuxième couche isolante 13, sans chevauchement avec la cavité 5. Par ailleurs, le premier composant électronique 2 et le deuxième composant électronique 3 comprennent chacun une terminaison 2a, 3a qui est brasée sur la plage de brasage en surface 14 formée dans la deuxième couche conductrice. En d'autres termes, le premier et le deuxième composant électroniques 2, 3 partagent une même plage de brasage en surface 14, de sorte que leurs joints de brasure 6 sont monolithiques sur cette plage de brasage en surface 14. Ce partage - avec une plage de brasage commune et un joint de brasure monolithique qui connecte les terminaisons respectives des composants - crée donc une connexion entre le premier et le deuxième composant électronique 2, 3, en gagnant substantiellement en surface en comparaison avec l'art antérieur qui, usuellement, éloignait les composants électroniques les uns des autres pour éviter leur collage lors du brasage (et en particulier lors de l'étape de refusion).

En plaçant le premier composant électronique 2 dans la cavité 5, on évite ainsi tout risque que le premier composant électronique 2 et le deuxième composant électronique 3 ne se collent côte à côte en raison de leur proximité, tout en réduisant la distance qui les sépare. Le premier composant électronique 2 reste en effet logé dans la cavité 5. Le partage de la plage de brasage en surface 14 permet ainsi d'accroître la densité d'implantation des composants sans risquer de déformer les joints de brasure 6, ce qui permet en outre d'augmenter leur durée de vie.

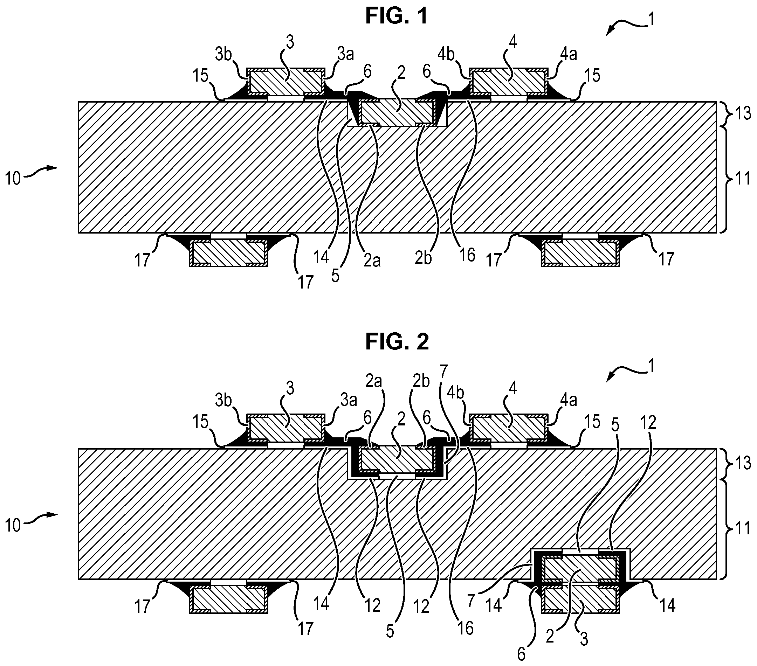

Le deuxième composant électronique 3 peut être placé sur la deuxième couche isolante 13 de sorte à ne pas chevaucher la cavité (figures 1 à 4).

Une telle technologie trouve particulièrement une application lorsque la carte électronique comprend un filtre différentiel. Il devient en effet possible de connecter ensemble des composants électroniques discrets 2, 3 en les brasant sur une même plage de brasage en surface 14, l'un des composants électroniques étant logé dans une cavité 5 tandis que l'autre est placé en surface à proximité de la cavité 5. Avantageusement, les composants électroniques 2, 3 brasés sur une même plage de brasage en surface 14 sont en outre rapprochés les uns des autres, en comparaison avec l'art antérieur qui les éloigne pour éviter qu'ils ne déforment le joint de brasure, ce qui permet en outre d'augmenter l'efficacité du filtre différentiel qui est directement liée à la distance entre les composants électroniques.

On notera que la cavité 5 est débouchante de sorte que le premier composant électronique 2 n'est pas enterré ni noyé dans une couche isolante mais simplement logé dans ladite cavité 5. Le premier composant électronique 2 reste donc réparable, puisque son accès n'est pas bloqué par des couches isolantes. De plus, comme nous le verrons dans ce qui suit, le procédé d'assemblage de la carte électronique 1 reste assez proche des procédés actuels. En particulier, les machines et process standards d'assemblage (et notamment de brasage) peuvent être utilisés, ce qui simplifie sa mise en œuvre à l'échelle industrielle.

Par « logé », on comprendra ici que le premier composant électronique 2 est sensiblement compris dans la cavité 5, c'est-à-dire qu'il affleure la face libre de la première couche isolante 11, qu'il est renfoncé par rapport à la face libre du circuit imprimé 10 (c'est-à-dire distant de la face libre, à l'intérieur de la cavité 5) ou qu'il en fait légèrement saillie (à très faible distance de la face libre). Dans tous les cas, au plus 10% de la hauteur du composant électronique dépasse de la cavité 5.

Dans les exemples de réalisation illustrés sur les figures, le circuit imprimé 10 est bicouche et comprend des composants électroniques 6 brasés sur la face opposée à la deuxième couche conductrice. Ceci n'est pas limitatif, le circuit imprimé 10 pouvant être monocouche ou multicouche. Par ailleurs, les première et deuxième couches conductrices étant traitées de sorte à former des plages de brasage, seules les plages de brasage correspondantes sont représentées et référencées sur les figures.

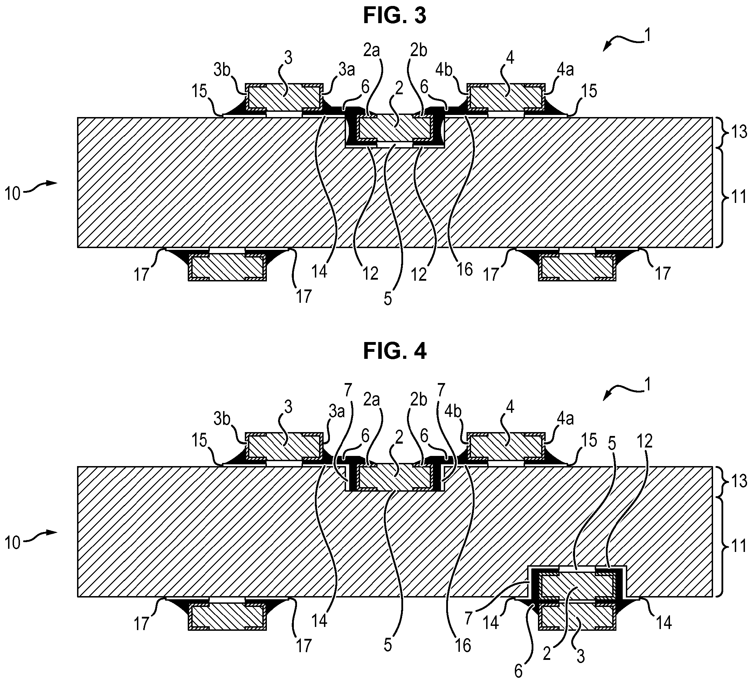

Dans une première variante de réalisation illustrée sur la figure 3, le circuit imprimé 10 comprend en outre la première couche conductrice traitée de sorte à former au moins une plage de brasage en fond de cavité 12. Par ailleurs, la cavité 5 débouche sur cette plage de brasage en fond de cavité 12 de sorte à la dévoiler. La terminaison 2a du premier composant électronique 2 est alors brasée sur la plage de brasage en fond de cavité 12, au fond de la cavité 5, en plus de la plage de brasage en surface 14.

Dans une deuxième variante de réalisation illustrée en figure 2, le circuit imprimé 10 comprend la première couche conductrice traitée de sorte à former au moins une plage de brasage en fond de cavité 12 et la cavité 5 débouche sur cette plage de brasage en fond de cavité 12 de sorte à la dévoiler. Par ailleurs, les parois de la cavité 5 sont métallisées de sorte à connecter la plage de brasage en fond de cavité 12 et la plage de brasage en surface 14. La terminaison 2a du premier composant électronique 2 est alors brasée sur la plage de brasage en fond de cavité 12, au fond de la cavité 5, sur la plage de brasage en surface 14 et sur les parois métallisées 7 de la cavité.

Dans une troisième variante de réalisation illustrée en figure 1, le circuit imprimé 10 est dépourvu de plage de brasage au fond de la cavité 5, dont les parois ne sont pas métallisées. La terminaison 2a du premier composant électronique 2 n'est donc brasée que sur la plage de brasage en surface 14. Dans cette variante de réalisation, la première couche isolante 11 et la deuxième couche isolante 13 peuvent donc être formées intégralement et en une seule pièce ou assemblées, par exemple par collage, de sorte à former un bloc monolithique.

Dans une quatrième variante de réalisation illustrée en figure 4, le premier circuit imprimé 10 est dépourvu de plage de brasage au fond de la cavité 5. En revanche, la deuxième couche conductrice est traitée de sorte à former l'au moins une plage de brasage en surface 14 et les parois de la cavité 5 sont métallisées. La terminaison 2a du premier composant électronique 2 est alors brasée sur la plage de brasage en surface 14 et sur les parois métallisées 7 de la cavité.

Bien entendu, lorsque le circuit imprimé comprend plusieurs cavités 5 dans chacune desquelles sont logés au moins un premier composant électronique 2, chaque premier composant électronique 2 peut être brasé sur le circuit imprimé selon l'une quelconque des variantes de réalisation décrite ci-dessus. En particulier, tous les composants électroniques 1 d'un même circuit imprimé ne sont pas nécessairement brasés de la même manière afin de pouvoir adapter la technique de brasage au type de terminaisons des différents composants électroniques.

Enfin, une même cavité 5 peut loger plusieurs premiers composants électroniques, brasés chacun sur une plage de brasage en surface 14 associée.

Le premier et le deuxième composant électronique 2, 3 peuvent chacun comprendre plusieurs terminaisons 2b, 3b, qui sont chacune brasées sur une plage de brasage en surface supplémentaire 15, 16 formée dans la deuxième couche conductrice. Le cas échéant, la ou les terminaisons supplémentaires du premier composant électronique 2 peut, le cas échéant, également être brasée(s) sur une ou plusieurs premières plages de brasage supplémentaires 12 associées au fond de la cavité 5. Par exemple, on a illustré sur les figures 1 à 4 un premier composant électronique 2 avec deux terminaisons 2a, 2b visibles, l'une des terminaisons 2a étant brasée sur la plage de brasage en surface 14, qui est partagée avec le deuxième composant électronique 3, l'autre des terminaisons 2b s'étendant à l'opposé et étant brasée sur la plage de brasage en surface 16. Le deuxième composant électronique 3 quant à lui a également deux terminaisons 3a, 3b visibles, l'une des terminaisons 3a étant brasée sur la plage de brasage en surface 14, qui est partagée avec la terminaison 2a du premier composant électronique 2, l'autre des terminaisons 3b s'étendant à l'opposé et étant placée à distance de la cavité 5 et de la plage de brasage en surface 14.

En pratique, c'est la configuration des terminaisons 2a, 3a et la dimension du premier et du deuxième composant électronique 2, 3 qui détermine les dimensions de la cavité 5, le nombre de plages de brasage 14, 15 et leur position sur la deuxième couche isolante 13.

Le cas échéant, le premier et le deuxième composant électronique 2, 3 peuvent également comprendre plusieurs terminaisons 2a, 3a partageant deux à deux une plage de brasage en surface 14 correspondante.

Dans une forme de réalisation, la carte électronique 1 peut comprendre des composants électroniques supplémentaires.

Dans un premier exemple de réalisation, le circuit imprimé peut être bicouche ou multicouche et comprendre une troisième couche conductrice, s'étendant à l'opposé de la deuxième couche conductrice par rapport à la première couche isolante 11, traitée de sorte à former une ou plusieurs troisièmes plages de brasage 17. Des composants électroniques peuvent alors être brasés sur des troisièmes plages de brasage 17. Le cas échéant, l'une de ces troisièmes plages de brasage 17 peut être partagée par deux composants électroniques adjacents, comme cela a été décrit pour la plage de brasage en surface 14. Ainsi, une cavité 5 débouchante peut également être formée dans la couche isolante sur laquelle est fixée la troisième couche conductrice afin d'y loger l'un des composants électroniques et l'une au moins des terminaisons de ce composant électronique peut être brasé sur une plage de brasage commune avec un autre composant électronique de sorte à ne former qu'un seul joint de brasure commun.

Dans un autre exemple de réalisation, qui peut être cumulé avec le premier, un troisième composant électronique 4 peut être brasé sur au moins une plage de brasage en surface supplémentaire 16 formée dans la deuxième couche conductrice. Optionnellement, ce troisième composant électronique 4 et le premier composant électronique 2 peuvent comprendre chacun une terminaison 2b, 4b brasée sur la plage de brasage en surface supplémentaire 16. Ainsi, le premier composant électronique 1 partage une plage de brasage en surface 16 et a un premier joint de brasure 6 commun avec le deuxième composant électronique 3 et un deuxième joint de brasure 6 commun avec le troisième composant électronique 4.

De préférence, le premier composant électronique 2 comprend un composant électronique discret du type CMS.

Le deuxième composant électronique 3 quant à lui peut comprendre un composant électronique discret du type CMS ou au moins un circuit imprimé sur lequel sont assemblés un ou plusieurs composants électroniques.

Une carte électronique 1 conforme à l'invention peut être obtenue conformément aux étapes de fabrication suivantes.

Dans une première forme de réalisation S, la crème à braser est sérigraphiée par-dessus le ou les premiers composants électroniques 2, prépositionnés dans la cavité 5, et le ou les deuxièmes composants électroniques 3 du dessus sont posés après crème à braser revêtant la deuxième couche isolante 13, après l'étape de sérigraphie.

Pour cela, au cours d'une première étape S1, un circuit imprimé 10 est fourni. Ce circuit imprimé 10 comprend la première couche isolante 11, la deuxième couche isolante 13 fixée sur la première couche isolante 11, au moins une deuxième couche conductrice fixée sur la deuxième couche isolante 13 et éventuellement une première couche conductrice s'étendant entre la première et la deuxième couche isolante 11, 13. Cette deuxième couche conductrice est prétraitée de sorte à former au moins une plage de brasage en surface 14, 15, 16 ou, au cours d'une sous-étape, est traitée de sorte à former la ou les deuxièmes plages de brasage 14, 15, 16. Au moins l'une des deuxièmes plages de brasage 14, 16 est formée suffisamment proche de la cavité 5 pour permettre le brasage d'un composant électronique logé dans la cavité 5.

Par exemple, chaque plage de brasage 12, 14, 15, 16 peut être obtenue par gravure de la couche conductrice correspondante.

La deuxième couche isolante 13 peut déjà être présente sur le circuit imprimé ou être appliquée sur la première couche isolante 11 par tout moyen. Par exemple, dans une première forme de réalisation, la deuxième couche isolante 13 peut être appliquée par photolithographie en surface sur la première couche isolante 11 (ou, le cas échéant, la première couche conductrice). Dans ce cas, les cavités 5 peuvent également être formées par photolithographie en surface. On pourra notamment se référer au document FR 3 069 128 au nom de la Demanderesse pour plus de détails sur les techniques de réalisation de la cavité 5.

Dans une deuxième forme de réalisation, la deuxième couche isolante 13 peut être rapportée et fixée sur la première couche isolante 11 (ou, le cas échéant, la première couche conductrice), par exemple par lamination ou collage à l'aide d'une couche adhésive. La couche adhésive peut comprendre tout type de matériau adhésif conventionnellement utilisé dans le domaine des circuits imprimés afin d'adhérer des couches ensemble, typiquement une colle époxy. La ou les cavités 5 peuvent alors être préformées dans la deuxième couche isolante 13 avant que celle-ci ne soit posée sur la face de connexion, ou encore après sa fixation. Par exemple, la ou les cavités 5 peuvent être formées par découpe de la deuxième couche isolante 13. La découpe peut être effectuée mécaniquement (à l'aide d'un outil de découpe de type fraisage mécanique ou perçage mécanique ou perçage laser avant pose sur la première couche isolante 11) ou par voie chimique. On pourra également se référer au document FR 3 069 128 au nom de la Demanderesse pour plus de détails sur les techniques de réalisation des cavités 5.

Optionnellement, selon la variante de réalisation choisie pour le brasage du premier composant électronique 2, les parois de la cavité 5 peuvent être métallisées.

Au cours d'une deuxième étape S2, au moins un premier composant électronique 2 est placé dans la cavité 5. Le premier composant électronique 2 est de préférence positionné de sorte à être complètement logé dans cette cavité 5, soit en étant renfoncé par rapport à la surface libre de la deuxième couche isolante 13, soit en affleurant ladite surface. Cela permet en effet d'appliquer la crème à braser par sérigraphie sur les deuxièmes plages de brasage 14, 15, 16. En variante, le premier composant électronique peut faire légèrement saillie de la cavité 5.

Dans tous les cas, le premier composant électronique 2 est posé au fond de la cavité 5. En d'autres termes, le premier composant électronique 2 est en contact avec le fond de la cavité 5, et non à distance de celui-ci. Avantageusement, le deuxième composant électronique 3 peut alors se trouver à une très faible distance de la surface de la deuxième couche conductrice 3 (inférieure à 50 micromètres), puisque les terminaisons 2a et 2b du premier composant électronique 2 ne s'étendent pas au-dessus des deuxièmes plages de brasage 14 et 16 mais sous la surface (ou affleurent la surface) de la deuxième couche isolante 13.

De plus, lorsque le premier composant électronique 2 est brasé sur au moins une deuxième plage 14, 15, 16, les terminaisons 2a, 2b du premier composant électronique 2 sont alors situées sous les plages de brasage associées, à l'intérieur de la cavité 5, ce qui permet d'augmenter la distance entre la plage de brasage et la terminaison du composant électronique 2 et donc ainsi de limiter les contraintes subies par les joints de brasure lorsque la carte électronique 1 subit un environnement sévère en température, en vibration ou en choc.

Optionnellement, un point de colle peut être appliqué au fond de la cavité 5 afin de maintenir en position le premier composant électronique 2 dans la cavité 5 lors de son brasage. La colle comprend par exemple une colle expoxy telle qu'une colle LOCTITE^{®} 3609.

Au cours d'une troisième étape S3, de la crème à braser comprenant un alliage métallique en suspension dans un flux de brasage est appliquée sur la ou les plages conductrices carte électronique et sur les terminaisons 2a, 2b du ou des premiers composants électroniques 2, par exemple par sérigraphie, alors que le ou les premiers composants électroniques 2 sont placés dans la cavité 5.

Par exemple, dans le cas où le premier circuit imprimé 10 ne comprend pas de plage de brasage en fond de cavité 12 dévoilée au fond de la cavité 5, la crème à braser est appliquée sur les deuxièmes plages de brasage 14, 15, 16 et sur les terminaisons 2a, 2b.

Dans le cas où le premier circuit imprimé 10 comprend des premières plages de brasage 12 dévoilées au fond de la cavité 5, de la crème à braser est bien entendu appliquée également sur ces plages de brasage 12, par sérigraphie et/ou par dépôt à l'aide d'une buse ou d'une aiguille (« dispensing » en anglais). De préférence, le dispensing est réalisé préalablement à la sérigraphie, par exemple préalablement à au placement du premier composant électronique 2 dans la cavité (entre les étapes S1 et S2).

Optionnellement, de la crème à braser peut être appliquée, par exemple par dispensing, sur les terminaisons 2a, 2b du premier composant électronique 2. Cela permet en effet de préparer la surface du haut des terminaisons 2a et 2b et de permettre que le joint brasé soit également réalisé sur cette surface. Dans le cas où la cavité 5 ne comprend pas de plage de brasage en fond de cavité 12 (voir par exemple figures 1 et 4, troisième et quatrième variantes de réalisation), cela permet en outre d'éviter que le premier composant électronique 2 ne remonte au-dessus de la surface libre de la deuxième couche isolante 13 sous l'effet des forces de mouillage.

Au cours d'une quatrième étape S4, au moins un deuxième composant électronique 3, et le cas échéant un troisième composant électronique 4, sont placés sur la crème à braser revêtant la deuxième couche conductrice 13, sans chevauchement avec la cavité 5 et à proximité de la ou des deuxièmes plages de brasage 14, 16.

Au cours d'une cinquième étape S5, un traitement thermique est appliqué à la carte électronique 1 de sorte à fixer le premier composant électronique 2, le deuxième composant électronique 3 et le cas échéant le troisième composant électronique 4 sur la ou les deuxièmes plages de brasage 14, 15, 16 de sorte à former un ou plusieurs joints de brasure 6 communs monolithiques.

Le traitement thermique comprend typiquement un traitement de refusion de l'alliage métallique présent dans la crème à braser afin d'obtenir des joints de brasure 6. Ici encore, on pourra se référer au document FR 3 069 128 au nom de la Demanderesse pour plus de détails sur le brasage par refusion.

Le premier composant électronique 2 et le deuxième composant électronique sont donc brasés simultanément sur la carte électronique 1. Le flux de la crème à braser vient donc simultanément préparer la surface du haut de la terminaison 2a du premier composant électronique 2 et du bas de la terminaison 3a du deuxième composant électronique 3, améliorant ainsi le rendement en fabrication.

Cette forme de réalisation S permet ainsi d'utiliser une technique de brasage éprouvée et industriellement aboutie et d'augmenter la productivité puisque les composants électroniques 2, 3, 4 peuvent être brasés simultanément, sans modifier sensiblement la configuration des lignes de production.

Dans une deuxième forme de réalisation S', la crème à braser est sérigraphiée préalablement à la pose des premier(s) et deuxième composants électroniques 2, 3 sur la carte électronique 1.

Pour cela, un premier circuit imprimé 10 est fourni au cours d'une première étape S1'. Cette étape est identique à la première étape S1 de la première forme de réalisation.

Au cours d'une deuxième étape S2', de la crème à braser comprenant un alliage métallique en suspension dans un flux de brasage est appliquée sur la ou les plages conductrices 14, 15, 16 de la carte électronique 1, par exemple par sérigraphie, ainsi que dans la cavité 5 à l'endroit où vont se placer les terminaisons 2a, 2b du premier composant électronique 2. Les premier(s), deuxième et éventuellement troisième composants électroniques 2, 3, 4 ne sont alors pas encore placés sur la carte électronique 1.

Par exemple, dans le cas où le premier circuit imprimé 10 ne comprend pas de plage de brasage en fond de cavité 12 dévoilée au fond de la cavité 5, la crème à braser est appliquée sur des deuxièmes plages de brasage 14, 15, 16 et dans la cavité 5, à l'emplacement destiné à recevoir les terminaisons 2a et 2b.

En revanche, lorsque le premier circuit imprimé 10 comprend une ou plusieurs premières plages de brasage 12 dévoilée au fond de la cavité 5, de la crème à braser est bien entendu appliquée également sur ces plages 12.

Optionnellement, de la crème à braser peut être appliquée, par exemple par dispensing, sur les terminaisons 2a, 2b du premier composant électronique 2. Cela permet en effet de préparer la surface du haut des terminaisons 2a et 2b et permettre que le joint brasé soit également réalisé sur cette surface. Dans le cas où la cavité ne comprend pas de plage de brasage en fond de cavité 12 (voir par exemple figures 1 et 4, troisième et quatrième variantes de réalisation), cela permet en outre d'éviter que le premier composant électronique 2 ne remonte au-dessus de la surface libre de la deuxième couche isolante 13 sous l'effet des forces de mouillage.

Les troisième et quatrième étapes S3' et S4' sont ensuite identiques aux deuxième et quatrième étapes S2, S4 de la première forme de réalisation.

En particulier, au cours de la troisième étape S3', au moins un premier composant électronique 2 est placé dans la cavité 5 en étant posé au fond de celle-ci. Pour cela, le premier composant électronique 2 peut notamment être enfoncé dans la crème à braser qui a été sérigraphiée dans la cavité 5, afin de garantir que le composant 2 se trouve bien au fond de la cavité 5.

Optionnellement, un point de colle peut être appliqué au fond de la cavité 5.

Au cours de la quatrième étape S4', le deuxième composant électronique 3 est placé sur la crème à braser revêtant la plage de brasage en surface 14 (et éventuellement la plage de brasage supplémentaire 16). Le deuxième composant électronique 3 peut être placé soit de sorte à ne pas chevaucher la cavité (exemples illustrés en figures 1 à 4)

Le cas échéant, un troisième composant électronique 4 peut être placé sur la crème à braser revêtant la plage de brasage en surface 14 et la plage de brasage en surface supplémentaire 15.

Au cours d'une cinquième étape S5', identique à la cinquième étape S5 de la première forme de réalisation, un traitement thermique est appliqué à la carte électronique 1 de sorte à fixer le premier composant électronique 2 dans la cavité 5, le deuxième composant électronique 3 et éventuellement le troisième composant électronique 4 sur la plage de brasage en surface 14.

Les composants électroniques 2, 3, 4 sont donc, ici encore, brasés simultanément sur la carte électronique 1, améliorant ainsi le rendement en fabrication, grâce à une technique de brasage éprouvée et industriellement aboutie.

Quelle que soit la forme de réalisation (sérigraphie après placement du premier composant électronique 2 ou préalablement), le premier composant électronique 2 est inséré dans la cavité 5. Pour cela, de manière connue en soi, les machines de pose utilisent habituellement deux mires imprimées à la surface du circuit imprimé leur permettant de déterminer la position du circuit imprimé, des plages de brasage, etc. dans le référentiel des mires afin d'appliquer la crème à braser lors de la sérigraphie et de poser les composants électroniques.

La Demanderesse s'est cependant aperçue du fait que les tolérances dimensionnelles et positionnelles de la cavité 5 dans la deuxième couche conductrice 13 étaient telles que la cavité 5 pouvait être décalée de 150 micromètres dans chaque direction par rapport au référentiel défini par les mires. Or, comme nous l'avons vu plus haut, il est nécessaire d'introduire le premier composant électronique 2 dans la cavité 5.

Afin de permettre l'introduction du premier composant électronique 2 dans la cavité 5 à l'échelle industrielle, une possibilité est donc d'augmenter la dimension de la cavité 5. Cela permet en effet de garantir le fait que, malgré la tolérance positionnelle, le premier composant électronique 2 peut être introduit dans la cavité 5 de manière automatisée. Toutefois, cela a pour conséquence d'augmenter la dimension des cavités de 300 micromètres suivant deux directions, ce qui est significatif pour des composants de petite taille.

En variante, en lieu et place des mires conventionnelles, le premier circuit imprimé 10 peut comprendre des cavités 8b formées dans la deuxième couche isolante 13 et jouant le rôle de mires 8. Ces cavités 8b sont alors formées pendant la même passe que la cavité 5 (ou des cavités 5) configurée pour recevoir un premier composant électronique 2, ce qui permet de s'affranchir du décalage des cavités 5 par rapport aux plages de brasage 14 et d'augmenter la certitude sur la position des cavités 5 dans le référentiel des cavités 8b formant les mires 8. Par exemple, les cavités 8b formant les mires 8 et les cavités 5 peuvent être réalisées à l'aide d'un même outil, par fraisage ou découpe laser.

De telles mires 8 peuvent par exemple être obtenues en fixant une couche métallique 8a sur la surface du premier circuit imprimé 10 et en creusant cette couche métallique 8a et la deuxième couche isolante 13 suivant un motif prédéfini de sorte à former la cavité 8b et d'obtenir la mire 8. La couche métallique 8a sert d'écran, la cavité 8b traversant la couche métallique 8a permettant, par contraste, de former le motif.

La couche métallique 8a peut par exemple comprend du cuivre. Elle peut être de forme similaire aux mires conventionnelles, par exemple de forme carrée. Par ailleurs, le cavité 8b peut présenter une section (dans le plan de la couche métallique) en forme de croix, de carré, de triangle, ou comprendre un ou plusieurs cercles concentriques, ou toute autre forme susceptible de former une cible.

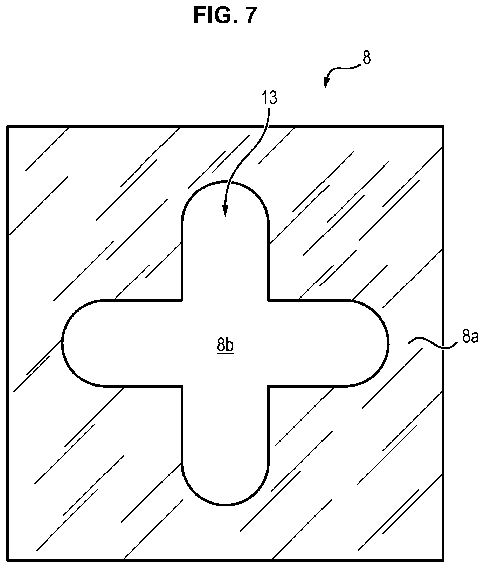

Un exemple de mire 8 a été illustré en figure 7.

## Revendications

1. Carte électronique (1) comprenant :
- un circuit imprimé (10) comprenant une première couche isolante (11), une deuxième couche isolante (13) fixée sur la première couche isolante (11) et dans laquelle est formée une cavité (5) débouchante et au moins une deuxième couche conductrice fixée sur la deuxième couche isolante (13), ladite deuxième couche conductrice étant traitée de sorte à former au moins une plage de brasage en surface (14, 16), et
- au moins un premier composant électronique (2) et au moins un deuxième composant électronique (3), le premier composant électronique (2) étant logé dans la cavité (5) de la deuxième couche isolante (13), le deuxième composant électronique (3) étant placé sur la deuxième couche isolante (13) et le premier composant électronique (2) et le deuxième composant électronique (3) comprenant chacun une terminaison (2a, 3a) brasée sur la plage de brasage en surface (14), la carte électronique étant **caractérisée en ce que** la plage de brasage en surface (14) est commune aux deux composants électroniques (2, 3), et **en ce que** le deuxième composant électronique (3) est placé sur la deuxième couche isolante (13) sans chevauchement avec la cavité (5).

2. Carte électronique (1) selon la revendication 1, comprenant en outre au moins une première couche conductrice fixée entre la première couche isolante (11) et la deuxième couche isolante (13) et étant traitée de sorte à former au moins une plage de brasage (12) en fond de cavité, ladite plage de brasage (12) en fond de cavité étant au moins partiellement dévoilée par la cavité (5) et la terminaison (2a) du premier composant électronique (2) étant en outre brasée sur la plage de brasage (12).

3. Carte électronique (1) selon la revendication 2, dans laquelle la cavité (5) présente une paroi latérale s'étendant entre la première couche conductrice et la plage de brasage en surface (14, 16), ladite paroi latérale étant métallisée.

4. Carte électronique (1) selon l'une des revendications 1 à 3, dans laquelle le deuxième composant électronique (3) comprend un circuit imprimé sur lequel sont assemblés un ou plusieurs composants électroniques, un composant monté en surface.

5. Carte électronique (1) selon l'une des revendications 1 à 4, dans laquelle le premier composant électronique (2) et/ou le deuxième composant électronique (3) comprennent au moins une terminaison supplémentaire (2a, 2b, 3a, 3b), lesdites terminaisons supplémentaires (2a, 2b, 3a, 3b) étant brasées sur des deuxièmes plages de brasage supplémentaires (15, 16) formées dans la deuxième couche conductrice.

6. Carte électronique (1) selon l'une des revendications 1 à 5, comprenant en outre une plage de brasage en surface additionnelle (16) formée dans la deuxième couche conductrice et un troisième composant électronique, placé sur la deuxième couche isolante (13) sans chevauchement avec la cavité (5), le premier composant électronique (2) et le troisième composant électronique (4) comprenant chacun une terminaison (2b, 4b) brasée sur la plage de brasage en surface additionnelle (16).

7. Procédé de fabrication d'une carte électronique (1) selon l'une des revendications 1 à 6 comprenant les étapes suivantes :
- fournir un circuit imprimé (10) (S1, S1') comprenant une première couche isolante (11), une deuxième couche isolante (13) fixée sur la première couche isolante (11) et au moins une deuxième couche conductrice fixée sur la deuxième couche isolante (13), ladite deuxième couche conductrice étant traitée de sorte à former au moins une plage de brasage en surface (14, 16) et comprenant une cavité (5) débouchante formée dans la deuxième couche isolante (13),
- placer (S2, S3') au moins un premier composant électronique (2) dans la cavité (5),
- placer (S4, S4') au moins un deuxième composant électronique (3) sur la deuxième couche isolante (13) sans chevaucher la cavité (5),
- braser (S5, S5') une terminaison (2a) du premier composant électronique (2) et une terminaison (3a) du deuxième composant électronique (3) sur la plage de brasage en surface (14).

8. Procédé selon la revendication 7, comprenant en outre une étape supplémentaire (S3, S2') au cours de laquelle de la crème à braser comprenant un alliage métallique en suspension dans un flux de brasage est appliquée sur l'au moins une plage de brasage en surface (14), ladite étape supplémentaire (S3, S2') étant réalisée avant ou après l'insertion du premier composant électronique (2) dans la cavité (5).

9. Procédé selon l'une des revendications 7 ou 8, dans lequel, au cours de l'étape (S2, S3') de placement de l'au moins un premier composant électronique (2), ledit premier composant électronique est posé au fond de la cavité (5).

10. Procédé selon l'une des revendications 7 à 9, comprenant en outre une étape de fixation d'une couche métallique (8a) sur la deuxième couche isolante (13) et de réalisation d'une cavité (8b) ayant un motif prédéfini (8b) à travers ladite couche métallique (8a) et la deuxième couche isolante (13) de sorte à former une mire (8).

## Patentansprüche

1. Elektronikkarte (1), umfassend:
- eine Leiterplatte (10), die eine erste Isolierschicht (11), eine zweite Isolierschicht (13), die auf der ersten Isolierschicht (11) befestigt ist und in der ein durchgehender Hohlraum (5) ausgebildet ist, und mindestens eine zweite leitende Schicht, die auf der zweiten Isolierschicht (13) befestigt ist, umfasst, wobei die zweite leitende Schicht so behandelt ist, dass sie mindestens einen Oberflächenlötbereich (14, 16) bildet, und
- mindestens eine erste elektronische Komponente (2) und mindestens eine zweite elektronische Komponente (3), wobei die erste elektronische Komponente (2) in dem Hohlraum (5) der zweiten Isolierschicht (13) untergebracht ist, wobei die zweite elektronische Komponente (3) auf der zweiten Isolierschicht (13) platziert ist und die erste elektronische Komponente (2) und die zweite elektronische Komponente (3) jeweils einen Abschluss (2a, 3a) aufweisen, der auf den Oberflächenlötbereich (14) gelötet ist, wobei die Elektronikkarte **dadurch gekennzeichnet ist, dass**
der Oberflächenlötbereich (14) beiden elektronischen Komponenten (2, 3) gemeinsam ist und dass die zweite elektronische Komponente (3) auf der zweiten Isolierschicht (13) platziert ist, ohne den Hohlraum (5) zu überlappen.

2. Elektronikkarte (1) nach Anspruch 1, die ferner mindestens eine erste leitende Schicht umfasst, die zwischen der ersten Isolierschicht (11) und der zweiten Isolierschicht (13) befestigt und so behandelt ist, dass sie mindestens einen Lötbereich (12) am Boden des Hohlraums bildet, wobei der Lötbereich (12) am Boden des Hohlraums zumindest teilweise durch den Hohlraum (5) freigelegt ist und der Abschluss (2a) der ersten elektronischen Komponente (2) ferner auf den Lötbereich (12) gelötet ist.

3. Elektronikkarte (1) nach Anspruch 2, wobei der Hohlraum (5) eine Seitenwand aufweist, die sich zwischen der ersten leitenden Schicht und dem Oberflächenlötbereich (14, 16) erstreckt, wobei die Seitenwand metallisiert ist.

4. Elektronikkarte (1) nach einem der Ansprüche 1 bis 3, wobei die zweite elektronische Komponente (3) eine Leiterplatte umfasst, auf der eine oder mehrere elektronische Komponenten verbunden sind, eine Komponente an der Oberfläche angebracht ist.

5. Elektronikkarte (1) nach einem der Ansprüche 1 bis 4, wobei die erste elektronische Komponente (2) und/oder die zweite elektronische Komponente (3) mindestens einen zusätzlichen Abschluss (2a, 2b, 3a, 3b) umfassen, wobei die zusätzlichen Abschlüsse (2a, 2b, 3a, 3b) auf zusätzliche zweite Lötbereich (15, 16) gelötet sind, die in der zweiten leitenden Schicht ausgebildet sind.

6. Elektronikkarte (1) nach einem der Ansprüche 1 bis 5, die ferner einen zusätzlichen Oberflächenlötbereich (16) umfasst, der in der zweiten leitenden Schicht ausgebildet ist, und eine dritte elektronische Komponente, die auf der zweiten isolierenden Schicht (13) ohne Überlappung mit dem Hohlraum (5) platziert ist, wobei die erste elektronische Komponente (2) und die dritte elektronische Komponente (4) jeweils einen Abschluss (2b, 4b) aufweisen, der auf den zusätzlichen Oberflächenlötbereich (16) gelötet ist.

7. Verfahren zur Herstellung einer Elektronikkarte (1) nach einem der Ansprüche 1 bis 6, das die folgenden Schritte umfasst:
- Bereitstellen einer Leiterplatte (10) (S1, S1'), die eine erste Isolierschicht (11), eine zweite Isolierschicht (13), die auf der ersten Isolierschicht (11) befestigt ist, und mindestens eine zweite leitende Schicht, die auf der zweiten Isolierschicht (13) befestigt ist, umfasst, wobei die zweite leitende Schicht so behandelt ist, dass sie mindestens einen Oberflächenlötbereich (14, 16) bildet und einen in der zweiten Isolierschicht (13) ausgebildeten durchgehenden Hohlraum (5) umfasst,
- Platzieren (S2, S3') mindestens einer ersten elektronischen Komponente (2) in dem Hohlraum (5),
- Platzieren (S4, S4') mindestens einer zweiten elektronischen Komponente (3) auf der zweiten Isolierschicht (13), ohne den Hohlraum (5) zu überlappen,
- Löten (S5, S5') eines Abschlusses (2a) der ersten elektronischen Komponente (2) und eines Abschlusses (3a) der zweiten elektronischen Komponente (3) auf die Oberflächenlötfläche (14).

8. Verfahren nach Anspruch 7, das ferner einen zusätzlichen Schritt (S3, S2') umfasst, in dem Lötpaste, die eine in einem Lötflussmittel suspendierte Metalllegierung enthält, auf den mindestens einen Oberflächenlötbereich (14) aufgetragen wird, wobei der zusätzliche Schritt (S3, S2') vor oder nach dem Einsetzen der ersten elektronischen Komponente (2) in den Hohlraum (5) durchgeführt wird.

9. Verfahren nach einem der Ansprüche 7 oder 8, wobei während des Schritts (S2, S3') des Platzierens der mindestens einen ersten elektronischen Komponente (2) die erste elektronische Komponente auf den Boden des Hohlraums (5) gesetzt wird.

10. Verfahren nach einem der Ansprüche 7 bis 9, das ferner einen Schritt des Befestigens einer Metallschicht (8a) auf der zweiten Isolierschicht (13) und des Herstellens eines Hohlraums (8b) mit einem vordefinierten Muster (8b) durch die Metallschicht (8a) und die zweite Isolierschicht (13) umfasst, so dass ein Testmuster (8) gebildet wird.

## Claims

1. An electronic circuit board (1) comprising:
- a printed circuit board (10) comprising a first insulating layer (11), a second insulating layer (13) attached to the first insulating layer (11) and in which is formed an open cavity (5) and at least a second conductive layer attached to the second insulating layer (13), said second conductive layer being treated such as to form at least one surface solder pad (14, 16), and
- at least a first electronic component (2) and at least a second electronic component (3), the first electronic component (2) being housed in the cavity (5) of the second insulating layer (13), the second electronic component (3) being placed on the second insulating layer (13) and the first electronic component (2) and the second electronic component (3) each comprising a termination (2a, 3a) soldered on the surface solder pad (14),
the electronic board (1) being **characterized in that** the surface solder pad (14) is shared by the two electronic components (2, 3), and **in that** the second electronic component (3) is placed on the second insulating layer (13) without overlapping with the cavity (5).

2. The electronic board (1) as claimed in claim 1, further comprising at least a first conductive layer attached between the first insulating layer (11) and the second insulating layer (13) and being treated such as to form at least one solder pad (12) at the bottom of the cavity, the solder pad (12) at the bottom of the cavity being at least partly revealed by the cavity (5) and the termination (2a) of the first electronic component (2) being also soldered on the solder pad (12).

3. The electronic board (1) as claimed in claim 2, wherein the cavity (5) has a side wall extending between the first conductive layer and the surface solder pad (14, 16), said side wall being metallized.

4. The electronic board (1) as claimed in one of claims 1 to 3, wherein the second electronic component (3) comprises a printed circuit board on which are assembled one or more electronic components, a surface-mount component.

5. The electronic board (1) as claimed in one of claims 1 to 4, wherein the first electronic component (2) and/or the second electronic component (3) comprise at least one additional termination (2a, 2b, 3a, 3b), said additional terminations (2a, 2b, 3a, 3b) being soldered on the second additional solder pads (15, 16) formed in the second conductive layer.

6. The electronic board (1) as claimed in one of claims 1 to 5, further comprising an additional surface solder pad (16) formed in the second conductive layer and a third electronic component, placed on the second insulating layer (13) without overlapping with the cavity (5), the first electronic component (2) and the third electronic component (4) each comprising a termination (2b, 4b) soldered on the additional surface solder pad (16).

7. A method for manufacturing an electronic board (1) as claimed in one of claims 1 to 6 comprising the following steps:
- supplying a printed circuit board (10) (S1, S1') comprising a first insulating layer (11), a second insulating layer (13) attached to the first insulating layer (11) and at least a second conductive layer attached to the second insulating layer (13), said second conductive layer being treated such as to form at least one surface solder pad (14, 16) and comprising an open cavity (5) formed in the second insulating layer (13),
- placing (S2, S3') at least a first electronic component (2) in the cavity (5),
- placing (S4, S4') at least a second electronic component (3) on the second insulating layer (13) without overlapping with the cavity (5),
- soldering (S5, S5') a termination (2a) of the first electronic component (2) and a termination (3a) of the second electronic component (3) on the surface solder pad (14).

8. The method as claimed in claim 7, further comprising an additional step (S3, S2') during which the soldering paste comprising a metallic alloy in suspension in a solder flux is applied to the at least one surface solder pad (14), said additional step (S3, S2') being performed before or after insertion of the first electronic component (2) into the cavity (5).

9. The method as claimed in one of claims 7 or 8, wherein, during the step (S2, S3') of placing the at least one first electronic component (2), said first electronic component is positionned at the bottom of the cavity (5).

10. The method as claimed in one of claims 7 to 9, further comprising a step of attaching a metal layer (8a) on the second insulating layer (13) and producing a cavity (8b) having a predefined pattern (8b) through said metal layer (8a) and the second insulating layer (13) such as to form a mark (8).
